Europäisches Patentamt

European Patent Office

Office européen des brevets

(11) Publication number: **0 482 661 A2**

# EUROPEAN PATENT APPLICATION

(21) Application number: **91118241.8**

(22) Date of filing: **25.10.91**

(51) Int. Cl.⁵: **H03K  3/037**

(30) Priority: **26.10.90 JP 289183/90**

(43) Date of publication of application:
**29.04.92 Bulletin  92/18**

(84) Designated Contracting States:
**DE FR GB**

(71) Applicant: **NEC CORPORATION**
**7-1, Shiba 5-chome Minato-ku**
**Tokyo 108-01(JP)**

(72) Inventor: **Kamisaki, Sachiko, c/o NEC**
**Corporation**
**7-1, Shiba 5-chome**
**Minato-ku, Tokyo(JP)**

(74) Representative: **Glawe, Delfs, Moll & Partner**
**Patentanwälte**
**Postfach 26 01 62 Liebherrstrasse 20**
**W-8000 München 26(DE)**

(54) **Power-on reset circuit.**

(57) A power-on reset circuit comprises a logic gate circuit such as NOR, NAND, etc., and an inverter circuit. A reset signal is obtained at an output of the logic gate circuit, which is also connected to an input of the inverter circuit. An output of the inverter is connected to one of two inputs of the logic gate circuit. An internal signal generated in an internal circuit in accordance with an external signal generated in an external circuit after the finish of a power-on is supplied to the remaining input of the logic gate circuit to change the output state thereof. Consequently, the generation of a reset signal becomes precise, and a power consumption is reduced.

*FIG.3*

## FIELD OF THE INVENTION

This invention relates to a power-on reset circuit, and more particularly to, a circuit for initializing internal circuits at the time of turning a power supply on in an integrated circuit such as a semiconductor memory circuit, etc.

## BACKGROUND OF THE INVENTION

In an integrated circuit such as a semiconductor memory circuit, etc., it is necessary to initialize internal circuits at the time of turning a power supply on. In a semiconductor memory, for instance, it is required to set data output terminals to be at a high impedance state at the time of turning a power supply on. In a serial access system of a dual-port memory, for instance, internal circuits are required to be completely initialized at the time of power-on to operate with a first clock signal which is supplied thereto at the very beginning time of operation, because no dummy clock signal is supplied thereto from an external circuit. For this purpose, a power-on reset circuit is provided in such an integrated circuit to generate a reset signal to be supplied to internal circuits which are thereby reset for initialization thereof.

One type of a conventional power-on reset circuit comprises first to third N-MOSFETs and a P-MOSFET, wherein the first and second N-MOSFETs are connected serially between a power supply and ground, and the third N-MOSFET and the P-MOSFET are connected serially between the power supply and ground. Gates of the first and second N-MOSFETs are commonly connected to the power supply, and drains thereof are connected to provide a nodal point which is connected commonly to gates of the P-MOSFET and the third N-MOSFET. The serially connected P-MOSFET and third N-MOSFET provide an inverter, wherein drains thereof are connected to provide a nodal point which is connected to an output terminal, from which a reset signal is obtained.

In operation, when the power supply is turned on, a power supply voltage is increased, and, when the power supply voltage becomes greater than a threshold voltage of the P-MOSFET, the reset signal is increased along the increase of the power supply voltage, so that the reset signal of a high level is generated to reset internal circuits. When the reset signal becomes greater than a level of the sum of a threshold voltage of the first N-MOSFET and a threshold voltage of the inverter, the reset signal becomes zero, so that initialization of the internal circuits finishes.

However, the conventional power-on reset circuit has disadvantages in that a level control of the reset signal is difficult to be realized, because the high and low levels of the reset signal are largely dependent on the threshold voltages of the N- and P-MOSFETs, and in that no generation of the reset signal or the generation of the reset signal having a defective high level which is less than a predetermined high level occurs, because operation is largely dependent on a time constant of the power-on reset circuit. The detail of the disadvantages will be again explained later.

## SUMMARY OF THE INVENTION

Accordingly, it is an object of the invention to provide a power-on reset circuit, in which a reset signal is precisely generated at any state at the time of turning a power supply on.

It is a further object of the invention to provide a power-on reset circuit, in which a level control of a reset signal is easily carried out.

It is a still further object of the invention to provide a power-on reset circuit, in which the generation of a reset signal is not dependent on a time constant of turning a power supply on.

It is a yet still further object of the invention to provide a power-on reset circuit, in which a power consumption is reduced.

According to the invention, a power-on reset circuit, comprises:

a logic gate circuit of a first predetermined input threshold voltage having first and second input terminals and an output terminal; and

an inverter circuit of a second predetermined input threshold voltage said first predetermined input threshold voltage being larger than said second predetermined input threshold voltage;

wherein an output terminal of the inverter is connected to the second input terminal of the logic gate circuit, and the output terminal of the logic gate circuit is connected to an input terminal of the inverter, whereby a reset signal is obtained at the output terminal of the logic gate circuit, and a state of the reset signal is changed, when a signal generated based on an external signal generated after a finish of a power-on is supplied to the first input terminal of said logic gate circuit.

## BRIEF DESCRIPTION OF THE DRAWINGS

This invention will be explained in more detail in conjunction with appended drawings, wherein:

Fig. 1 is a circuit diagram showing a conventional power-on reset circuit;

Fig. 2 is a timing chart explaining operation of the conventional power-on reset circuit;

Fig. 3 is a circuit diagram showing a power-on reset circuit of a first preferred embodiment according to the invention;

Figs. 4A and 4B are circuit diagrams showing a NOR circuit and an inverter circuit included in the power-on reset ciruit of the first preferred embodiment; and

Fig. 5 is a timing chart explaining operation in the first preffered embodiment; and

Figs. 6 and 7 are circuit diagrams showing power-on reset circuits of second and third preffered embodiments according to the invention.

## DESCRIPTION OF THE PREFERRED EMBODIMENTS

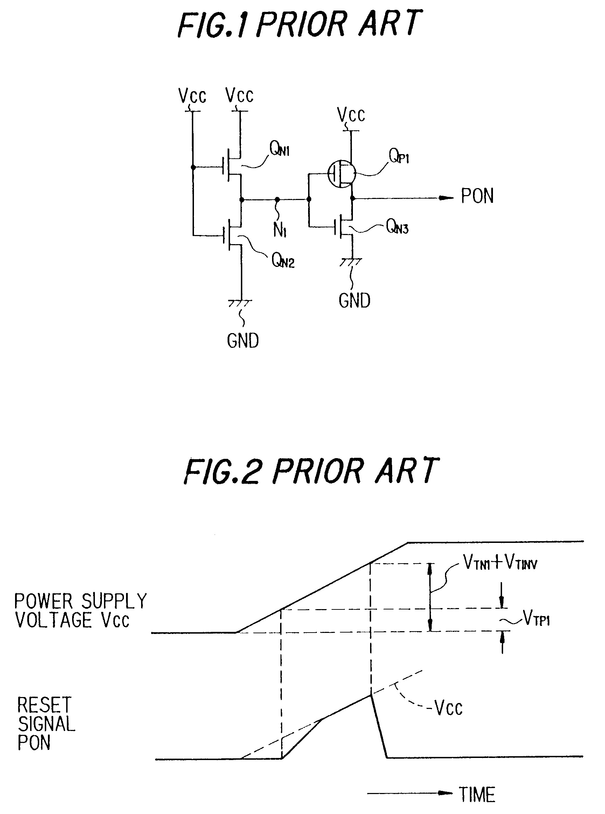

Before describing a power-on reset circuit of the preferred embodiments according to the invention, the aforementioned conventional power-on reset circuit will be explained in Figs. 1 and 2.

Fig. 1 shows the conventional power-on reset circuit which comprises N-MOSFETs $Q_{N1}$ and $Q_{N2}$ connected in serial between a power supply Vcc and ground GND, and a P-MOSFET $Q_{P1}$ and an N-MOSFET $Q_{N3}$ connected in serial between the power supply Vcc and ground GND, wherein gates of the N-MOSFETs $Q_{N1}$ and $Q_{N2}$ are commonly connected to the power supply Vcc, gates of the P- and N-MOSFETs $Q_{P1}$ and $Q_{N3}$ are commonly connected to a nodal point $N_1$ between the N-MOSFETs $Q_{N1}$ and $Q_{N2}$, and a reset signal PON is obtained at a nodal point of drains of the P- and N-MOSFETs $Q_{P1}$ and $Q_{N3}$. In this power-on reset circuit, an inverter circuit is provided by the P- and N-MOSFETs $Q_{P1}$ and $Q_{N3}$.

In operation, when a power supply is turned on, the power supply voltage Vcc is increased as shown Fig. 2. When the power supply voltage Vcc becomes greater than a threshold voltage $V_{TP1}$ of the P-MOSFET $Q_{P1}$, the reset signal PON is increased to be a high level. This high level reset signal PON is supplied to internal circuits which are thereby reset to be initialized. Then, when the power supply voltage Vcc becomes greater than a voltage $(V_{TN1} + V_{TINV})$ which is a sum of threshold voltage $V_{TN1}$ of the N-MOSFET $Q_{N1}$ and a threshold voltage $V_{TINV}$ of the inverter circuit composed of the P- and N-MOSFETs $Q_{P1}$ and $Q_{N3}$, the reset signal PON becomes a low level, so that the initialization of the internal circuits finishes.

As described above, a level control of the reset signal PON is carried out dependent on threshold voltages of the N- and P-MOSFETs. Therefore, precise reset operation is difficult to be realized, unless the level control of the reset signal PON is sufficient.

In addition, the reset signal PON is generated largely dependent on a time constant of the power-on reset circuit. In more detail, a time constant of the nodal point $N_1$ is much lower than a time constant of the reset signal PON. Therefore, if a time constant of the power-on is extremely of a high speed, a level of the nodal point $N_1$ becomes greater than the threshold voltage $V_{TINV}$ of the inverter, before the reset signal PON becomes a high level to reset the internal circuits. As a result, the high level reset signal PON is not obtained.

In order to overcome this malfunction of the power-on reset circuit, a current capability of the P-MOSFET $Q_{P1}$ is required to be large. In fact, however, the current capability of the P-MOSFET $Q_{P1}$ is set to be extremely small, thereby decreasing a power consumption of the power-on reset circuit. For this circuit design, the threshold voltage $V_{TINV}$ of the inverter becomes low to provide a relation of $V_{TIN} \leftleftarrows V_{TN3}$, where $V_{TN3}$ is a threshold voltage of the N-MOSFET $Q_{N3}$ for providing the inverter together with the P-MOSFET $Q_{P1}$. As a result, if a time constant of the power-on is extremely of a low speed, an input signal of the inverter is inverted therein, before the power supply voltage Vcc reaches to a predetermined level, so that a reset signal PON having a predetermined high level is not obtained, although the reset signal PON reaches to the level $(V_{TN1} + V_{TINV})$. This occurs because the threshold voltage $V_{TINV}$ is nearly equal to the low threshold voltage $V_{TN3}$. Consequently, the power supply voltage Vcc is still increased, even after the reset signal PON is turned to be a low level. Thus incomplete initialization occurs in the internal circuits to result in the malfunction thereof.

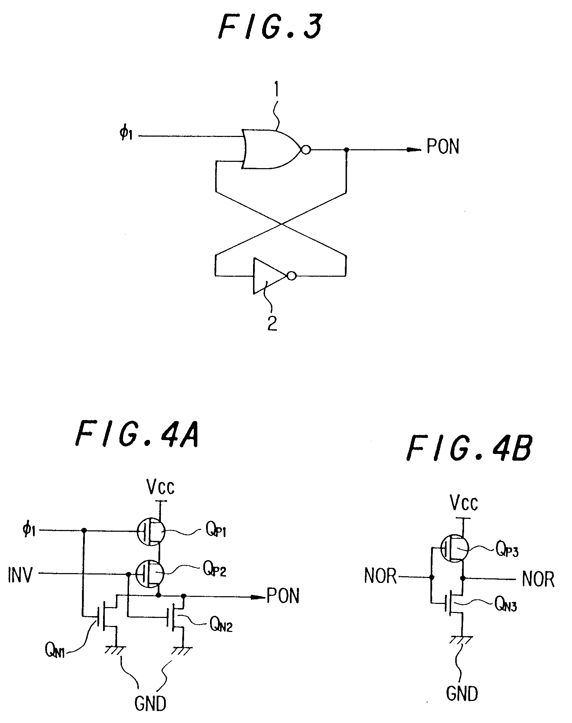

Next, a power-on reset circuit of the first preferred embodiment according to the invention will be explained in Figs. 3, and 4A and 4B.

Fig. 3 shows the power-on reset circuit which comprises a NOR circuit 1 and an inverter circuit 2, wherein an internal signal $\phi$, generated in an internal circuit in accordance with an external signal supplied thereto after turning a power supply on is supplied to a first input of the NOR circuit 1, an output signal of the inverter circuit 2 is supplied to a second input thereof, and an output signal of the NOR circuit 1 is supplied to a reset signal output terminal and an input of the inverter circuit 2. In this power-on reset circuit, an input threshold voltage of the NOR circuit 1 is set to be larger than that of the inverter circuit 2, and the difference of the input threshold voltages is set to be inherently larger than an offset amount of this power-on reset circuit. As apparent from the circuit structure, this power-on reset circuit is a flip flop circuit composed of the NOR circuit 1 and the inverter circuit 2.

Fig. 4A shows the NOR circuit 1 which comprises P-MOSFETs $Q_{P11}$ and $Q_{P12}$, and N-MOSFETs $Q_{N11}$ and $Q_{N12}$. The P-MOSFETs $Q_{P11}$ and $Q_{P12}$ are connected in serial between a power supply Vcc and a reset signal output terminal, and the N-MOSFETs $Q_{N11}$ and $Q_{N12}$ are connected in parallel between the reset signal output terminal and ground. In this NOR circuit 1, the internal signal $\phi$, is supplied to gates of the P- and N-MOSFETs $Q_{P11}$ and $Q_{N11}$, and the output signal IVN of the inverter circuit 2 is supplied to gates of the P- and N-MOSFETs $Q_{P12}$ and $Q_{N12}$.

Fig. 4B shows the inverter circuit 2 which comprises P- and N-MOSFETs $Q_{P13}$ and $Q_{N13}$ connected complementally between the power supply and ground, wherein the output signal of the NOR circuit 1 is supplied to gates of the P- and N-MOSFETs $Q_{P13}$ and $Q_{N13}$, and a nodal point between drains of the P- and N-MOSFETs $Q_{P13}$ and $Q_{N13}$ is an output terminal of the inverter circuit 2.

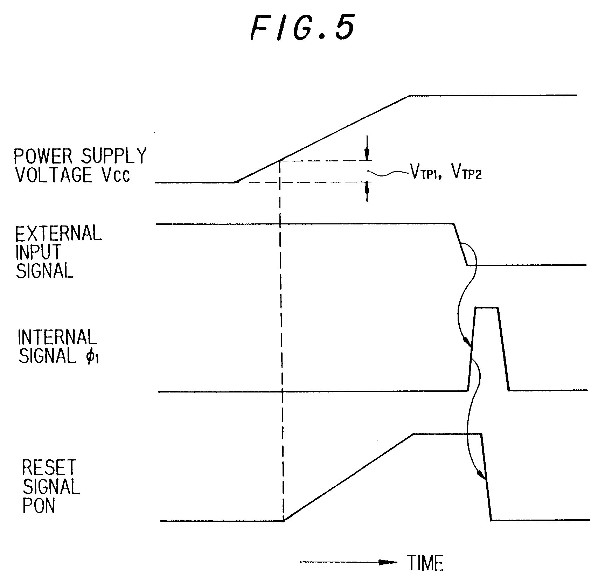

Operation of this power-on reset circuit will be explained in Fig. 5.

When the power supply Vcc is turned on, the power supply voltage Vcc is increased. When the power supply voltage Vcc becomes greater than threshold voltages $V_{TP11}$ and $V_{TP12}$ of the P-MOSFETs $Q_{P11}$ and $Q_{P12}$, a reset signal PON starts increasing as shown therein. Thus, a reset signal PON of a high level is generated to be supplied to internal circuits which are thereby reset to realize initialization therein. Thereafter, the internal signal $\phi$, is generated in accordance with the external signal supplied thereto after turning the power supply on. The internal signal $\phi$, is supplied to the first input of the NOR circuit 1, so that the reset signal PON becomes a low level. Thus, the reset state is released.

In this first preferred embodiment, a large difference is set between the threshold voltages of the NOR circuit 1 and the inverter circuit 2, so that an output state of the flip flop is determined to provide a reset signal PON. Therefore, the reset signal is precisely generated without any influence of a rising speed of the power supply voltage Vcc, threshold voltages of the MOSFETs, etc. Further, a power consumption is largely reduced in this power-on reset circuit, because it is composed of the NOR circuit 1 and the inverter circuit 2. In this first preferred embodiment, the NOR circuit 1 is replaced by another logic gate circuit such as NAND circuit, etc.

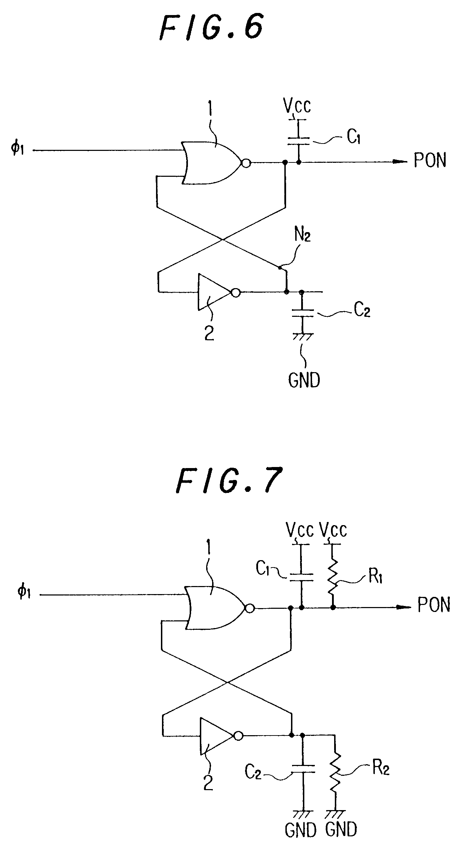

Fig. 6 shows a power-on reset circuit of the second preferred embodiment according to the invention. In this second preferred embodiment, capacitances $C_1$ and $C_2$ are added to the structure of the first preferred embodiment. The capacitance $C_2$ is connected between the output terminal of the NOR circuit 1 and the power supply Vcc, and the capacitance $C_2$ is connected between the output terminal (nodal point $N_2$) of the inverter circuit 2 and ground.

In this second preferred embodiment, the reset signal PON becomes a high level at the time of the power-on along the power supply voltage Vcc, because the capacitance $C_1$ is added, and a signal of the nodal point $N_2$ is hard to be a high level, because a value of capacitances which are charged by the inverter circuit 2 is increased by the addition of the capacitance $C_2$. As a result, the operation state of the flip flop composed of the NOR gate 1 and the inverter circuit 2 is easier to be fixed, so that the operation stability of this power-on reset circuit becomes higher than that of the first preferred embodiment.

Fig. 7 shows a power-on reset circuit of the third preferred embodiment according to the invention. This power-on reset circuit is additionally provided with resistances $R_1$ and $R_2$ which are connected in parallel with the capacitances $C_1$ and $C_2$, respectively, in the second preferred embodiment.

In this third preferred embodiment, the operation state of the flip flop is much easier to be fixed than that of the second preferred embodiment, so that the power-on reset circuit provides much more stabled operation as compared to that of the second preferred embodiment. As a matter of course, no power consumption is substantially increased due to the addition of the capacitances $C_1$ and $C_2$, and the resistances $R_1$ and $R_2$.

As explained in the first to third preferred embodiments, a flip flop is composed of a logic gate circuit and an inverter circuit which have different threshold voltages. Therefore, an output state of the flip flop is fixed at the time of turning a power supply on by a difference of the threshold voltages, and an output signal of the flip flop is supplied as a reset signal to internal circuits. Then, a signal based on an external signal after the power-on, for instance, an internal signal generated in the internal circuits is supplied to the logic gate circuit, so that the output state of the flip flop is changed to provide the release of the reset state.

For this reason, a reset signal is precisely generated in the invention without any influence of a rising speed of the power supply voltage and threshold voltages of the MOSFETs. Further, a power consumption is largely reduced as compared to the conventional power-on reset circuit, because the power-on reset circuit is composed of the logic gate circuit and the inverter circuit in the invention.

Although the invention has been described with respect to specific embodiment for complete and clear disclosure, the appended claims are not to be thus limited but are to be construed as embodying all modification and alternative constructions that may occur to one skilled in the art which fairly fall within the basic teaching herein set forth.

**Claims**

1. A power-on reset circuit, comprises;

   a logic gate circuit of a first predetermined input threshold voltage having first and second input terminals and an output terminal; and

   an inverter circuit of a second predetermined input threshold voltage said first predetermined input threshold voltage being larger than said second predetermined input threshold voltage;

   wherein an output terminal of said inverter is connected to said second input terminal of the logic gate circuit, and said output terminal of said logic gate circuit is connected to an input terminal of said inverter, whereby a reset signal is obtained at said output terminal of said logic gate circuit, and a state of said reset signal is changed, when a signal generated based on an external signal generated after a finish of a power-on is supplied to said first input terminal of said logic gate circuit.

2. A power-on reset circuit, according to claim 1, wherein:

   said logic gate circuit is a circuit selected from a NOR circuit and a NAND circuit.

3. A power-on reset circuit, according to claim 1, wherein:

   said logic gate circuit is connected at said output terminal to a first electrode of a first capacitance, a second electrode of said first capacitance being connected to a power supply; and

   said inverter circuit is connected at said output terminal to a first electrode of a second capacitance, a second electrode of said second capacitance being connected to ground.

4. A power-on reset circuit, according to claim 3, wherein:

   said logic gate circuit is connected to a first resistance which is connected in parallel with said first capacitance; and

   said inverter circuit is connected to a second resistance which is connected in parallel with said second capacitance.

# FIG.1 PRIOR ART

# FIG.2 PRIOR ART

## FIG.3

## FIG.4A

## FIG.4B

# FIG.5

## FIG.6

## FIG.7